# DEMANDE DE BREVET EUROPEEN

(11) **EP 1 498 756 A1**
(43) Date de publication de la demande: **19.01.2005**
(21) Numéro de dépôt: 03291781.7
(22) Date de dépôt: 17.07.2003
(51) Int. Cl.: G02B 7/02, H04N 5/225

(54) **Méthode de fixage d'une lentille par rapport à un capteur optique dans un dispositif de prise d'images**

(71) Demandeur: STMicroelectronics S.A., 92120 Montrouge (FR); STMicroelectronics S.r.l., 20041 Agrate Brianza (Milano) (IT); STMicroelectronics Pte Ltd., Singapore 569508 (SG)
(72) Inventeur: Magni, Pierangelo, 20058 Villasanta (Milano) (IT); Brechignac, Remi, 38000 Grenoble (FR); Kho, Chek Lim, 310142 Singapore (SG); Loo, Kum Weng, 576079 Singapore (SG)
(74) Mandataire: Ferrari, Barbara

(57) **Abrégé**

On décrit une méthode pour fixer une lentille (8) d'un groupe (11) optique par rapport à un capteur optique (4) dans un dispositif de prise d'images comprenant les phases de:
- loger le capteur optique (1) dans un boîtier (2),
- fixer un support (12) inférieur du groupe (11) optique au boîtier (1);
- aligner un support (13) supérieur du groupe (11) optique, où la lentille (8) est logée, au capteur optique (1) de façon à aligner un point de focalisation de la lentille (8) par rapport au capteur optique (1),
- souder le support (13) supérieur au support (12) inférieur.

Avantageusement selon l'invention, la méthode prévoit que la phase de soudure est effectuée par ultrasons.

## Description

### Domaine d'application

La présente invention concerne une méthode de fixage d'une lentille d'un groupe optique par rapport à un capteur optique dans un dispositif de prise d'images.

L'invention concerne aussi un dispositif de prise d'images comprenant un capteur optique logé dans un boîtier et un groupe optique comprenant à son tour un support inférieur fixé audit boîtier et un support supérieur de logement d'une lentille dudit groupe optique.

L'invention concerne en particulier, mais pas exclusivement, une méthode pour fixer une lentille dans une enveloppe plastique faisant partie d'un appareil photo ayant des caractéristiques fonctionnelles adaptées à permettre que ce fixage soit stable dans les phases suivantes d'assemblage de l'appareil lui-même et la description suivante est faite par référence à ce domaine d'application dans le seul but d'en simplifier l'exposition.

### Art antérieur

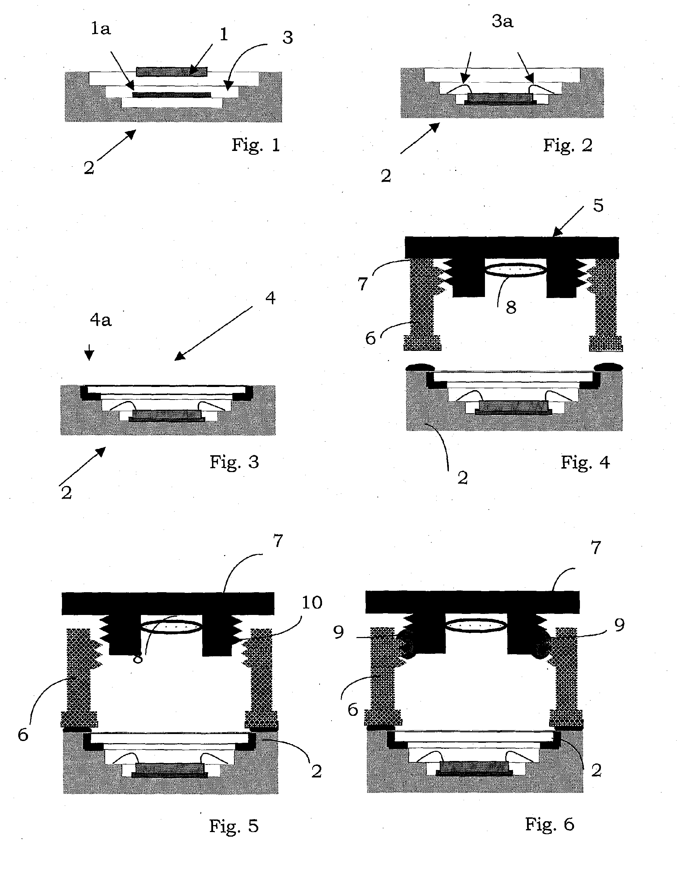

Comme l'on connaît bien, les dispositifs portables de prise d'images, tels que les appareils photo ou les téléphones portables pourvus d'une installation photographique, sont équipés de capteurs 1 pour la prise d'images qui sont positionnés dans un boîtier [housing] 2 pourvu d'une cavité 3 de logement et ils sont fixés au boîtier 2 par interposition d'une couche adhésive 2a comme illustré à la figure 1.

Après avoir connecter électriquement par le moyen de fils électriques 3a le capteur 1 et le boîtier 2, par exemple par «wire bonding» comme illustré à la figure 2, la cavité 3 de logement est donc fermée par un couvercle 4 scellant par interposition d'une couche adhésive 4a. Le couvercle 4 est par exemple en verre comme illustré à la figure 3.

Un groupe optique 5 est donc fixé sur le boîtier 2. En général, le groupe optique 5 comprend un support 6 [lens holder] et un cylindre 7 [lens barrel] de logement d'une lentille 8 qui est fixée au support 6, comme illustre à la figure 4.

En particulier, pendant une phase de focalisation de la lentille 8 par rapport au capteur 1, le support 6 est fixé solidairement au boîtier 2 et le cylindre 7 est déplacé par rapport au support 6 pour trouver le bon point de focalisation du groupe optique 5 comme illustré à la figure 5.

En particulier, le cylindre 7 peut être tourné, déplacé horizontalement et/ou verticalement jusqu'à atteindre la meilleure position du point de focalisation de la lentille 8 par rapport au capteur 1.

Lé bon point de focalisation ayant été trouvé, le cylindre 7 doit être bloqué au support 6.

Une première solution technique antérieure pour bloquer le cylindre 7 au support 6 est illustrée à la figure 6.

Selon cette solution, une couche 9 adhésive est interposée entre le cylindre 7 et le support 6. Pour permettre un fixage stable, des portions de cylindre 7 et de support 6 coopérant entre elles, pendant la phase de fixage, sont pourvues de rainures 10 qui permettent de mieux supporter la couche 9 adhésive.

Même si avantageuse sous plusieurs aspects, cette première solution a plusieurs inconvénients.

En particulier, ce type de solution se base essentiellement sur des productions manuelles, car la distribution de cette couche 9 adhésive entre le cylindre 7 et le support 6 est difficile à contrôler dans des équipements automatiques de production.

En outre, ne pouvant pas distribuer uniformément la couche 9 adhésive entre le cylindre 7 et le support 6, il est facile que la lentille 8 perd l'alignement avec le capteur 1, car on a vérifié que le cylindre 7 est attiré dans la direction où il y a une plus grande quantité de couche 9 adhésive.

Une deuxième solution pour bloquer le cylindre 7 au support 6 prévoit au contraire l'utilisation d'une bague métallique ondulée ou faite de matériaux différents des matériaux composant le cylindre 7 et le support 6 qui est interposée entre le cylindre 7 et le support 6. La pression exercée par la bague tend à maintenir le cylindre 7 en position par rapport au support 6.

Même si correspondant au but, cette solution aussi a des inconvénients.

En effet après la focalisation il est difficile d'assurer le maintien par la bague de la position relative entre le cylindre 7 et le support 6.

Les dispositifs de prise d'images réalisés avec ces techniques antérieures ont donc des problèmes de répétitivité qui en limitent l'applicabilité au niveau industriel, en augmentant les coûts de fabrication. En particulier, ne déplaçant que de quelques microns l'axe et/ou le point de focalisation de la lentille par rapport au capteur, l'image détectée par le capteur lui-même n'est plus uniforme. En particulier, une portion d'image détectée en correspondance des bords de la lentille est de qualité considérablement différente par rapport à une portion d'image détectée en correspondance du centre de la lentille.

Le problème technique à la base de la présente invention est de fournir une méthode de fixage d'une lentille optique par rapport à un capteur optique dans des dispositifs électroniques capables de prendre des images ayant des caractéristiques fonctionnelles adaptées à permettre un fixage stable en dépassant les limites et les inconvénients qui affectent à présent les méthodes réalisées selon la technique antérieure.

### Résumé de l'invention

L'idée de solution à la base de la présente invention est de fixer par soudure un support supérieur contenant une lentille optique à un support inférieur connecté solidairement à un boîtier contenant un capteur optique, juste après avoir trouvé l'alignement entre la lentille et le capteur.

Avantageusement, cette soudure est réalisée sur un ou plusieurs points par ultrasons.

Sur la base de cette idée de solution le problème technique est résolu par une méthode du type précédemment indiqué et défini par la partie caractérisante de la revendication 1.

Le problème est résolu aussi par un dispositif du type précédemment indiqué et défini par la partie caractérisante de la revendication 12.

Les caractéristiques et avantages de la méthode et du dispositif selon l'invention apparaîtront de la description suivante d'un de ses exemples de réalisation donné à titre indicatif et non limitatif avec référence aux figures annexées.

### Brève description des figures

Dans les figures:
- les figures 1 à 6 montrent des vues en section verticale d'un dispositif de prise d'images pendant des opérations de focalisation et de fixage selon la technique antérieure,
- la figure 7 montre une vue en section verticale d'un dispositif de prise d'images pendant une phase de soudure de la méthode selon l'invention,
- la figure 8 montre une vue en section verticale d'une forme de réalisation alternative d'un dispositif de prise d'images pendant une phase de soudure de la méthode selon l'invention,
- la figure 9 montre une vue en perspective du dispositif de prise d'images obtenu avec la méthode selon l'invention pendant la phase de soudure,
- la figure 10 est une vue latérale du dispositif de prise d'images obtenu avec la méthode selon l'invention après la phase de soudure.

### Description détaillée

Se référant aux figures 5 à 8, on décrit une méthode de fixage d'un groupe optique comprenant une lentille optique par rapport à un capteur optique dans un dispositif de prise d'images.

Pour simplicité d'exposition, on va attribuer les même références numérales aux éléments structurellement et fonctionnellement égaux à la technique antérieure.

Comme on a déjà décrit se référant à la technique antérieure, dans un dispositif de prise d'images, un capteur 1 pour la prise d'images est positionné dans un boîtier [housing] 2 pourvu d'une cavité 3 de logement et il est fixé au boîtier 2 par interposition d'une couche adhésive 2a comme illustré à la figure 1.

Après avoir connecté électriquement par le moyen de fils électriques 3a le capteur 1 et le boîtier 2, par exemple par «wire bonding», la cavité 3 de logement est fermée par un couvercle 4 scellant par interposition d'une couche adhésive 4a. Le couvercle 4 est par exemple en verre.

Selon l'invention, un groupe optique 11 est donc fixé sur le boîtier 2. Le groupe optique 11 comprend un support 12 inférieur nommé «lens holder» et un support 13 supérieur nommé «lens barrel» de logement d'une lentille 8 qui est fixée au support 12 inférieur. Le support 13 supérieur a au moins une portion 13a de rétention, correspondant à une zone de rétention de la lentille 8, ayant des dimensions telles pour être logée dans le support 12 inférieur.

En particulier, pendant une phase d'alignement ou focalisation de la lentille 8 du groupe optique 11 par rapport au capteur 1, le support 12 inférieur est fixé solidairement au boîtier 2 et le support 13 supérieur est déplacé par rapport au support 12 inférieur.

En particulier, le support 13 supérieur est tourné, déplacé horizontalement et/ou verticalement jusqu'à atteindre une position optimale du point de focalisation de la lentille 8 par rapport au capteur 1.

Avantageusement, cette phase de focalisation est effectuée par prise d'une série d'images captées par le capteur 1 à travers la lentille 8 et bloquant le support 13 supérieur dans la position où une image était détectée parfaitement focalisée dans les points désirés.

La position optimale de la lentille 8 ayant été trouvée, le support 13 supérieur doit être bloqué au support 12 inférieur.

Selon l'invention, le support 13 supérieur est fixé au support 12 inférieur par soudure. En particulier, une pluralité de rayons d'énergie vont incider le support 13 supérieur de façon à souder le support 13 supérieur au support 12 inférieur.

Avantageusement, le support 12 inférieur est plus mince en correspondance des point de incidance de ces rayons d'énergie.

Pour effectuer la soudure on peut utiliser une énergie laser. En réalité, l'utilisation de l'énergie laser a des désavantages dans ce domaine d'application particulier. En effet pendant le procédé de soudure le laser produit des poussières [dust or soot] qui peuvent aller dans le dispositif de prise d'images, et qui peuvent donc se déposer sur le couvercle 4 protégeant le capteur 1 ou sur la lentille 8, empêchant un fonctionnement correct et une prise soignée d'images. Aussi désavantageusement, les particules composant ces poussières peuvent être «mobiles» dans la cavité formée par le couvercle 4 et le groupe comprenant le support 12 inférieur et le support 13 supérieur, compromettant la stabilité de prise de l'image finale.

En outre, une moindre variation de matériel ou de position relative de la sonde laser provoquerait une dispersion considérable de la soudure elle-même.

Dans une forme de réalisation particulièrement avantageuse on utilise un faisceau d'ultrasons pour effectuer la soudure.

En particulier, on utilise une buse 15 [ultrasonic transducer] qui vibre à haute fréquence et qui transforme l'énergie de vibration en énergie thermique. Cette buse 15 est positionnée en contact avec le support 13 supérieur arrivant à fondre [melt] les interfaces entre le support 13 supérieur et le support 12 inférieur seulement dans la zone intéressée. Autrement dit, l'énergie perdue par la buse 15 vibrant quand elle est en contact avec la surface à souder est convertie en chaleur fondant ensemble les deux interfaces plastiques formant le support 13 supérieur et le support 12 inférieur.

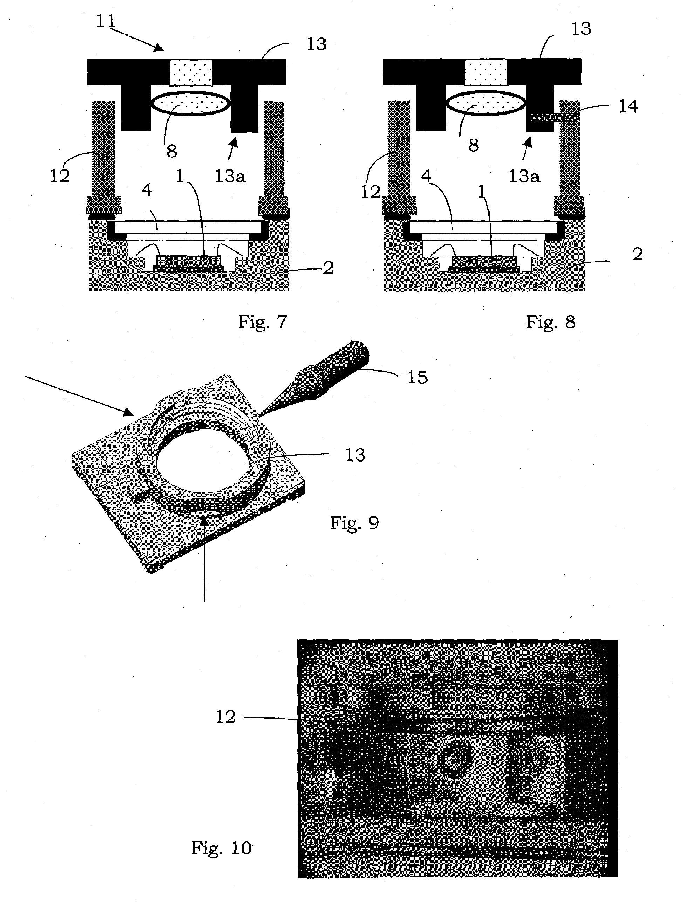

Pour un fixage plus uniforme on peut utiliser plusieurs buses différentes pour effectuer la soudure, ces buses sont positionnées dans un seul plan et elles sont disposées entre elles de façon à se distribuer symétriquement le long du périmètre du support 12 inférieur. Dans une forme de réalisation préférée les buses sont trois et elles sont disposées entre elles à 120°, comme illustré à la figure 9 par des flèches.

Avantageusement, une portion 14 de renfort de la buse 15 ultrasonique peut faire partie d'un module qui va être englobé dans la soudure elle-même renforçant d'ici la soudure qui non seulement fond les deux interfaces mais qui les bloque aussi mécaniquement comme illustré à la figura 8.

Avantageusement, le champ des fréquences utilisé pour la soudure à ultrasons est 20 à 80 kHz.

Selon une autre forme de réalisation avantageuse, la soudure peut être réalisée par une sonde [probe] thermique. En particulier on utilise une ou plusieurs buses réchauffées, à une température supérieure à la température de fusion du matériel formant le support 13 supérieur et le support 12 inférieur, qui est placée en contact avec le support 13 supérieur. La chaleur est donc transférée de la sonde thermique au matériel, le fondant et formant ainsi une soudure des interfaces entre le support 13 supérieur et le support 12 inférieur.

La soudure à ultrasons, ainsi que la soudure thermique, sont facilement contrôlables car l'énergie est mieux distribuée dans la soudure elle-même et des poussières qui pourraient empirer les performances du dispositif final de prise d'images ne se produisent pas, comme il arrive utilisant une énergie laser.

En outre, ces types de soudures sont beaucoup plus stables par rapport au moment de torsion qui est utilisé pour contrôler la qualité du procédé de fabrication.

En conclusion, la méthode de fixage selon l'invention n'impose pas de limites particulières de dimension ou forme aux supports 12 et 13.

En outre elle n'est pas limitée au fixage aux côtés de la portion 13a de rétention du support 13 supérieur contenant la lentille 8, n'importe quelle partie de ce support pouvant être utilisée pour réaliser la soudure du support 13 supérieur au support 12 inférieur.

Avantageusement, en outre, la méthode de fixage selon l'invention ne requiert pas de filetages pour le fixage du support 13 supérieur au support 12 inférieur. En particulier, les interfaces entre le support 12 inférieur et le support 13 supérieur ne doivent pas être filetées et elles sont donc plus simples à construire.

Enfin, on peut facilement apporter des changements dans les parties du groupe optique pour s'adapter à différentes typologies de dispositif de prise d'images.

Avantageusement, toute la méthode de fixage selon l'invention est facilement automatisable. Les phases et le matériel employés peuvent être facilement intégrés dans un procédé traditionnel de fabrication d'enveloppes protectrices.

En conclusion, la méthode selon l'invention permet de réaliser une soudure à ultrasons ou thermique ou une combinaison des deux, c'est-à-dire du type thermosonique, pour fixer une lentille optique d'un groupe optique par rapport à un capteur, la soudure étant facilement monitorable en termes de qualité et en temps réel. Ce monitorage est disponible par rétroaction des signaux ultrason ou thermoson et de l'énergie utilisée pour la soudure: par exemple amplitude, fréquence, impédance, énergie et d'autres paramètres qui ne sont pas directement liés au transducteur ou sonde: par exemple la vitesse de pénétration et le point final, le point de départ et d'arrêt des ultrasons.

## Revendications

1. Méthode pour fixer une lentille (8) d'un groupe (11) optique par rapport à un capteur optique (4) dans un dispositif de prise d'images comprenant les phases de:
- loger ledit capteur optique (1) dans un boîtier (2),
- fixer un support (12) inférieur dudit groupe (11) optique audit boîtier (2);
- aligner un support (13) supérieur dudit groupe (11) optique, où ladite lentille (8) est logée, audit capteur optique (1) de façon à aligner un point de focalisation de ladite lentille (8) par rapport audit capteur optique (1),
- souder ledit support (13) supérieur audit support (12) inférieur.

2. Méthode selon la revendication 1, **caractérisée en ce que** ladite phase de soudure se produit par au moins un faisceau énergétique.

3. Méthode selon la revendication 1, **caractérisée en ce que** ladite phase de soudure se produit par au moins un faisceau à ultrasons.

4. Méthode selon la revendication 1, **caractérisée en ce que** ladite phase de soudure se produit par au moins un faisceau thermique.

5. Méthode selon la revendication 1, **caractérisée en ce que** ladite phase de soudure se produit par au moins un faisceau thermosonique.

6. Méthode selon l'une des revendications 2 à 5, **caractérisée en ce que** ladite phase de soudure prévoit l'utilisation d'une pluralité de faisceaux d'énergie en correspondance d'une pluralité de points desdits supports (12) inférieur et (13) supérieur.

7. Méthode selon la revendication 6, **caractérisée en ce qu'**elle prévoit une pluralité de faisceaux disposés dans un plan et formant entre eux des angles essentiellement égaux.

8. Méthode selon la revendication 6, **caractérisée en ce qu'**elle prévoit une phase de conformation dans laquelle ledit support (13) supérieur est aminci en correspondance des points où l'on réalise ladite soudure avant d'effectuer ladite phase de soudure.

9. Méthode selon la revendication 1, **caractérisée en ce que** ladite phase d'alignement est effectuée par prise d'une série d'images captées par ledit capteur optique (1) à travers ladite lentille (8) et bloquant ledit support (13) supérieur dans une position où une image prise est parfaitement focalisée.

10. Méthode selon la revendication 4, **caractérisée en ce que** ladite phase de soudure est effectuée par une buse (15) ultrasonique comprenant au moins une portion (14) de renfort destinée à être englobée dans une zone de soudure réalisée par ladite phase de soudure.

11. Dispositif de prise d'images comprenant un capteur optique (1) logé dans un boîtier (2) et un groupe (11) optique comprenant à son tour un support (12) inférieur fixé audit boîtier (2) et un support (13) supérieur de logement de ladite lentille (8), **caractérisé en ce que** ledit support (13) supérieur et ledit support (12) inférieur ont entre eux au moins un point de soudure.

12. Dispositif de prise d'images selon la revendication 11, **caractérisée en ce que** ledit support (13) supérieur et ledit support (12) inférieur ont entre eux une pluralité de points de soudure.

13. Dispositif de prise d'images selon la revendication 12, **caractérisée en ce que** ladite pluralité de points de soudure est distribuée symétriquement le long du périmètre dudit support (12) inférieur.

14. Dispositif de prise d'images selon la revendication 11, **caractérisée en ce que** ledit au moins un point de soudure comprend une portion (14) de renfort.
